# EUROPEAN PATENT SPECIFICATION

(11) **EP 3 000 915 B1**
(45) Date of publication and mention of the grant of the patent: **13.09.2017**
(21) Application number: 14800704.0
(22) Date of filing: 13.05.2014
(51) Int. Cl.: C23C 22/74, C21D 8/12, H01F 1/18, C23C 22/08, C23C 22/62, H01B 1/22, H01B 1/24, H01B 3/00, C09D 1/00, C09D 7/12, C23C 18/12

(54) **ELECTROMAGNETIC STEEL SHEET HAVING INSULATING COATING FILM ATTACHED THERETO**
ELEKTROMAGNETISCHES STAHLBLECH MIT DARAN BEFESTIGTEM ISOLATIONSBESCHICHTUNGSFILM
TÔLE D'ACIER ÉLECTROMAGNÉTIQUE SUR LAQUELLE EST FIXÉ UN FILM DE REVÊTEMENT ISOLANT

(30) Priority: 23.05.2013 JP 2013108456
(43) Date of publication of application: 30.03.2016
(73) Proprietor: JFE Steel Corporation, Tokyo, 100-0011 (JP)
(72) Inventor: SASHI, Kazumichi, Tokyo 100-0011 (JP); MURAMATSU, Naoki, Tokyo 100-0011 (JP); FUJIBAYASHI, Nobue, Tokyo 100-0011 (JP); KUBOTA, Takahiro, Tokyo 100-0011 (JP)
(74) Representative: Grünecker Patent- und Rechtsanwälte PartG mbB
(86) International application number: PCT/JP2014/002517
(87) International publication number: WO 2014/188679

(56) References cited:
- WO-A1-2005/090636
- JP-A- 2000 178 760
- JP-A- 2002 249 881
- JP-A- 2004 322 079
- JP-A- 2006 169 567
- JP-A- 2007 119 799
- JP-A- 2008 127 664
- JP-A- 2008 127 674
- US-A1- 2013 115 444

## Description

### Technical Field

The present invention relates to an electrical steel sheet provided with an insulating coating which has high corrosion resistance and high adhesion.

### Background Art

Insulating coatings for electrical steel sheets used in motors, transformers, and the like are required to have not only interlaminar insulation resistance but also various characteristics such as ease of processing and forming and stability during storage and use. Since the characteristics required for the insulating coatings for electrical steel sheets vary depending on the application, various insulating coatings have been developed in accordance with the intended applications.

In general, an electrical steel sheet is subjected to punching, shearing, bending, and the like while the electrical steel sheet is formed into a product. When an electrical steel sheet is subjected to punching, shearing, bending, and the like, the magnetic properties of the electrical steel sheet may be degraded due to residual strain. In order to prevent the degradation of the magnetic properties from occurring, stress relief annealing is commonly performed at about 700°C to 800°C. In the case where stress relief annealing is performed, it is required for the insulating coating to have heat resistance high enough to withstand heat applied during stress relief annealing.

Insulating coatings for electrical steel sheets are classified into the following three types:

(1) an inorganic coating capable of withstanding stress relief annealing, in which greater importance is placed on weldability and heat resistance,
(2) a resin-containing inorganic coating (i.e., coating which has inorganic with some organic materials) capable of withstanding stress relief annealing, which is produced with the aim of achieving both high punchability and high weldability, and
(3) a special-purpose organic coating that cannot be subjected to stress relief annealing.

Among these insulating coatings, the insulating coatings described in (1) and (2) are general-purpose ones which are capable of withstanding the heat applied during stress relief annealing. Chromium compounds have been commonly used as an inorganic component included in these insulating coatings. An example of the insulating coating of type (2) including a chromium compound is a chromate-based insulating coating.

The chromate-based insulating coating of type (2), which can be produced by a one-coating-one-baking method, has been widely used because it markedly improve the punchability of an electrical steel sheet provided with the insulating coating compared with the inorganic coating of type (1).

For example, Patent Literature 1 describes a sheet iron having an electrically insulating coating produced by applying a coating liquid onto the surface of a base electrical steel sheet, followed by baking by an ordinary method. The coating liquid is prepared by mixing a bichromate aqueous solution containing at least one type of bivalent metal with a resin emulsion, as an organic resin, in which the vinyl acetate/VeoVa ratio is 90/10 to 40/60, and an organic reducing agent such that the amount of resin emulsion is 5 to 120 parts by weight (in terms of resin solid content) and the amount of organic reducing agent is 10 to 60 parts by weight relative to 100 parts by weight of CrO₃ contained in the aqueous solution.

However, due to increasing environmental concerns, there has been a demand for electrical steel sheets provided with an insulating coating that does not include a chromium compound in the field of electrical steel sheets.

Accordingly, electrical steel sheets provided with an insulating coating that does not include a chromium compound have been developed. For example, Patent Literature 2 discloses an insulating coating that does not include a chromium compound and is capable of enhancing the above-described coating characteristics such as punchability. The insulating coating described in Patent Literature 2 includes a resin and colloidal silica (alumina-containing silica). Patent Literature 3 discloses an insulating coating including one or more components selected from colloidal silica, alumina sol, and zirconia sol and a water-soluble or emulsion resin. Patent Literature 4 discloses an insulating coating that does not include a chromium compound, is mainly composed of a phosphate, and includes a resin.

However, the electrical steel sheets provided with an insulating coating that does not include a chromium compound may have lower corrosion resistance and lower adhesion (i.e., adhesion between the insulating coating and the electrical steel sheet) than those provided with an insulating coating including a chromium compound. While attempts have been made to enhance corrosion resistance and adhesion in each of the techniques described in Patent Literatures 2 to 4, more suitable approaches to enhancing these coating characteristics have been desired.

In regard to this point, for example, Patent Literature 5 discloses a method in which the Fe content in a coating composed of a polyvalent metal phosphate is limited to 0 ≤ Fe/P ≤ 0.10 in order to enhance corrosion resistance and adhesion. Patent Literature 6 discloses a method in which elution of Fe is limited in order to improve the characteristics of an insulating coating while the specific values are not described. That is, Patent Literature 6 proposes an insulating coating including a resin, an Al compound, a Si compound, and one or more easily ionized elements (except Cr) other than Al which have greater ionization tendency than Fe and are capable of becoming a divalent ion in an aqueous medium. Examples of the easily ionized elements which are described in Patent Literature 6 are Mg, Zn, Zr, Ca, Sr, Mn, and Ba.

As described above, it is generally considered that the characteristics of an insulating coating are likely to be degraded due to elution of Fe into the insulating coating. It is difficult to control the elution of Fe in the case where the coating is produced by applying a paint that does not contain a chromium compound, where chromium compound produces a passivation effect, directly onto the surface of an electrical steel sheet, followed by baking. Thus, it is difficult to enhance the properties of the insulating coating to a sufficient degree.

### Citation List

### Patent Literature

PTL 1: Japanese Examined Patent Application Publication No. 60-36476
PTL 2: Japanese Unexamined Patent Application Publication No. 10-130858
PTL 3: Japanese Unexamined Patent Application Publication No. 10-46350
PTL 4: Japanese Patent No. 2944849
PTL 5: Japanese Patent No. 3718638
PTL 6: Japanese Unexamined Patent Application Publication No. 2005-240131

### Summary of Invention

### Technical Problem

The present invention was made in order to address the above-described problems. An object of the present invention is to provide an electrical steel sheet provided with an insulating coating which has high corrosion resistance and high adhesion.

### Solution to Problem

The inventors of the present invention have conducted extensive studies in order to address the above-described problems and, as a result, found that, among Zr-containing insulating coatings, an insulating coating including a specific amount of Fe unexpectedly has better coating characteristics (i.e., corrosion resistance and adhesion of the insulating coating) than the other Zr-containing insulating coatings. Thus, the present invention was completed. More specifically, the present invention provides the following:

(1) An electrical steel sheet provided with an insulating coating, the electrical steel sheet provided with an insulating coating including an electrical steel sheet and an insulating coating disposed on the electrical steel sheet. The insulating coating includes Zr and Fe. The content of Zr in the insulating coating is 0.05 to 1.50 g/m² in terms of ZrO₂. The compositional ratio between Zr and Fe is such that the molar ratio of Fe to Zr, that is, the ratio of the amount (moles) of Fe included in the insulating coating to the amount (moles) of Zr included in the insulating coating, is 0.10 to 2.00.
(2) The electrical steel sheet provided with an insulating coating described in (1), in which the insulating coating further includes Si and the compositional ratio between Zr and Si is such that the molar ratio of Si to Zr, that is, the ratio of the amount (moles) of Si included in the insulating coating to the amount (moles) of Zr included in the insulating coating, is 2.00 or less.
(3) The electrical steel sheet provided with an insulating coating described in (1) or (2), in which the insulating coating further includes P and the compositional ratio between Zr and P is such that the molar ratio of P to Zr, that is, the ratio of the amount (moles) of P included in the insulating coating to the amount (moles) of Zr included in the insulating coating, is 1.50 or less.
(4) The electrical steel sheet provided with an insulating coating described in any one of (1) to (3), in which the insulating coating further includes an organic resin and the compositional ratio between Zr and the organic resin is such that the solid content ratio of the organic resin to Zr, that is, the ratio of the solid content (g) of the organic resin included in the insulating coating to the amount (g) of Zr included in the insulating coating in terms of the mass of ZrO₂, is 0.50 or less.

### Advantageous Effects of Invention

The electrical steel sheet provided with an insulating coating according to the present invention has high corrosion resistance and high adhesion (i.e., adhesion between the insulating coating and the electrical steel sheet).

In addition, according to the present invention, the electrical steel sheet provided with an insulating coating has high corrosion resistance and the above-described high adhesion although the insulating coating does not include Cr. Brief Description of Drawings

[Fig. 1] Fig. 1 is a diagram illustrating an example of the result of depth profiling conducted using an Auger electron spectrometer.
[Fig. 2] Fig. 2 is a diagram illustrating the relationship between the adhesion between an insulating coating and an electrical steel sheet and molar ratio (Fe/Zr).

### Description of Embodiments

Hereinafter, embodiments of the present invention are described specifically. It should be noted that the present invention is not limited by the following embodiments.

The electrical steel sheet provided with an insulating coating according to the present invention includes an electrical steel sheet and an insulating coating disposed on the electrical steel sheet.

### Electrical Steel Sheet

The electrical steel sheet used in the present invention is not limited to a specific electrical steel sheet. For example, the electrical steel sheet may include any element that can be included in cemical composition of common electrical steel sheets. Examples of the elements of the electrical steel sheet include Si and elements used for enhancing magnetic properties and the like, such as Mn, P, Al, S, N, and V. The balance of the composition of the electrical steel sheet includes Fe and incidental impurities.

The type of electrical steel sheet is not particularly limited. Any type of electrical steel sheet, such as a "mild iron sheet" (i.e., electrical iron sheet) having high magnetic flux density, a general-purpose cold-rolled steel sheet such as SPCC, and a non-oriented electrical steel sheet including Si and Al in order to increase specific resistance, can be suitably used in the present invention.

Specifically, the electrical steel sheet having the following properties may be suitably used: an iron loss W_{15/50} of 16.0 W/kg or less and preferably 13.0 W/kg or less; and/or a magnetic flux density B₅₀ of 1.5 T or more and preferably 1.6 T or more. Common electrical steel sheets include Si and/or Al such that the total content thereof is about 0.1% to 10.0% by mass.

### Insulating Coating

An insulating coating is formed on the electrical steel sheet. In general, the insulating coating has an interlaminar insulation resistance of 1 Ω·cm²/sheet or more. The insulating coating includes Zr and Fe. The insulating coating preferably includes at least one component selected from Si, P, and an organic resin.

Since the insulating coating includes Zr, the insulating coating has high toughness. It is considered that this tough coating is formed due to Zr atoms forming a network with one another or with other inorganic compounds. Zr is capable of forming such a network since Zr has three or more bonds and also has a strong bonding force to oxygen and thereby strongly bind to oxides, hydroxides, and the like that are present on the surface of Fe. In order to impart corrosion resistance to the electrical steel sheet provided with an insulating coating while producing the advantageous effect of using Zr, it is necessary to control the amount of the Zr compound deposited to be 0.05 g/m² or more in terms of ZrO₂. If the amount of the Zr compound deposited is less than 0.05 g/m² in terms of ZrO₂, the above-described corrosion resistance may be degraded due to insufficient coating. If the amount of the Zr compound deposited exceeds 1.50 g/m², the adhesion between the insulating coating and the electrical steel sheet and the corrosion resistance of the electrical steel sheet provided with an insulating coating may be degraded because the risk of cracking in the coating is increased. Therefore, the amount of the Zr compound deposited needs to be controlled to be 1.50 g/m² or less. The lower and upper limits of the amount of the Zr compound deposited are preferably set to 0.20 g/m² and 1.00 g/m², respectively, from the viewpoint of the properties of the coating.

The Zr content in the insulating coating is represented in terms of ZrO₂ because it is considered that a Zr-O(-Zr) linkage, the maximum number of which per Zr atom is four, serves as a basis for forming the structure of the coating.

Adding a specific amount of Fe to the Zr-containing insulating coating enhances the characteristics of the insulating coating. As described above, it has been considered that Fe included in an insulating coating deteriorates the characteristics of the insulating coating. However, as described in Examples below, when an insulating coating includes Zr, adding a specific amount of Fe to the insulating coating enhances the characteristics of the insulating coating. The reason that the coating characteristics are enhanced in the above-described manner is not clear, but is presumably due to some interaction between Zr and Fe included in the insulating coating.

In order to produce the above-described advantageous effect of adding Fe to the Zr-containing insulating coating, it is necessary to determine the Fe content in the insulating coating with consideration of the Fe content and the Zr content in the insulating coating. Specifically, it is necessary to determine the Fe content such that the molar ratio between Zr and Fe (i.e., amount (moles) of Fe included in the insulating coating/amount (moles) of Zr included in the insulating coating, which may be referred to as "molar ratio (Fe/Zr)" hereinafter) is 0.10 to 2.00. If the molar ratio (Fe/Zr) is less than 0.10, adhesion may be degraded. This is presumably because the interaction between Zr and Fe which occurs at the interface between the insulating coating and the electrical steel sheet is reduced. If the molar ratio (Fe/Zr) exceeds 2.00, the Fe content becomes excessive relative to the four bonds of a Zr atom, which may deteriorate the above-described adhesion and corrosion resistance. The molar ratio (Fe/Zr) is preferably set to 0.2 to 1.5.

The molar ratio (Fe/Zr) in the insulating coating refers to a molar ratio determined by Auger electron spectroscopy. In order to determine the molar ratio (Fe/Zr) by Auger electron spectroscopy, in which an analysis is conducted in the depth direction while performing sputtering, Fe concentrations and Zr concentrations are measured at points above the position at which the intensity of Zr is reduced to half the initial value, and the averages of the Fe concentrations and Zr concentrations are calculated. The number of the measurement points is ten or more, and the average thereof is considered to be the molar ratio (Fe/Zr). It is considered that the insulating coating extends to the position at which the intensity of Zr is reduced to half the initial value. It is needless to say that the portion beyond the position at which the intensity of Zr is reduced to half the initial value is the electrical steel sheet.

It is possible to form a Fe-containing insulating coating on the electrical steel sheet by using Fe compounds, which will be described later, for forming the insulating coating. Alternatively, it is also possible to introduce Fe included in the electrical steel sheet to the insulating coating instead of using a Fe compound.

The insulating coating preferably includes Si. Adding Si to the insulating coating enhances the insulating property of the insulating coating. Further, adding Si to an insulating coating including specific amounts of Zr and Fe further enhances the adhesion between the insulating coating and the electrical steel sheet. In order to produce the above-described advantageous effect, the insulating coating preferably includes Si such that the molar ratio between Zr and Si (i.e., amount (moles) of Si included in the insulating coating/amount (moles) of Zr included in the insulating coating, which may be referred to as "molar ratio (Si/Zr)" hereinafter) is 0.30 or more.

It is preferable to control the Si content such that the molar ratio (Si/Zr) is 2.00 or less. Controlling the molar ratio (Si/Zr) to be 2.00 or less limits, to a sufficient degree, degradation of adhesion which may be caused by setting the Si content high relative to the Zr content. It is considered that adding Si to the insulating coating enables a Si-O linkage to be introduced to the structure of the coating.

The insulating coating preferably includes P. Adding P to an insulating coating including specific amounts of Zr and Fe further enhances the corrosion resistance of the electrical steel sheet provided with an insulating coating. In order to achieve the advantageous effect, that is, the enhancement of corrosion resistance, the insulating coating preferably includes P such that the molar ratio between Zr and P (i.e., amount (moles) of P included in the insulating coating/amount (moles) of Zr included in the insulating coating, which may be referred to as "molar ratio (P/Zr)" hereinafter) is 0.20 or more. The molar ratio (P/Zr) is more preferably set to 0.50 or more.

The molar ratio (P/Zr) is preferably controlled to be 1.50 or less. Even if the P content is increased such that the molar ratio (P/Zr) exceeds 1.50, it is not possible to further enhance the above-described corrosion resistance. On the contrary, the corrosion resistance may be degraded.

The insulating coating preferably includes an organic resin. Adding an organic resin to the insulating coating enhances the corrosion resistance, scratch resistance, and punchability of the electrical steel sheet provided with an insulating coating. In order to achieve the advantageous effect, the content of the organic resin in the dry coating is preferably controlled to be 5% by mass or more. The term "content in the dry coating" used herein refers to the proportion of the organic resin included in the insulating coating formed on the surface of a steel sheet. The amount of the dry coating can also be determined on the basis of the amount of component (i.e., solid content) remaining after the coating liquid for forming an insulating coating on the steel sheet is dried at 180°C for 30 minutes.

Further, adding an organic resin to an insulating coating including specific amounts of Zr and Fe markedly enhances the coating characteristics (i.e., corrosion resistance) of the electrical steel sheet provided with an insulating coating. In order to enhance the coating characteristics, the content of the organic resin in the insulating coating is preferably controlled such that the solid content ratio between the organic resin and Zr (i.e., (organic resin content)/Zr content in terms of the mass of ZrO₂) is 0.50 or less.

In addition to the above-described components, commonly used additives such as a surfactant, a rust-preventive agent, a lubricant, and an antioxidant, other inorganic and organic compounds, and the like may be added to the insulating coating. Examples of the organic compounds include an organic acid used as a contact inhibitor that stops inorganic components and an organic resin from coming into contact with each other. Examples of the organic acid include a polymer and a copolymer that include a carboxylic acid. Examples of the inorganic compounds include boron and pigments. The above-described other components (hereinafter, may be referred to as "additives") may be added to the insulating coating as long as the advantageous effects of the present invention are not impaired. In the present invention, it is preferable to add the above-described additives to the insulating coating such that the mass ratio between the additives and Zr (i.e., (total mass of the solid components of the additives)/Zr content in terms of the mass of ZrO₂) is 1.00 or less. It is more preferable to add the above-described additives to the insulating coating such that the mass ratio between the additives and Zr (i.e., (total mass of the solid components of the additives)/Zr content in terms of the mass of ZrO₂) is 0.50 or less.

One of the features of the present invention is that it is possible to enhance the corrosion resistance of the electrical steel sheet provided with an insulating coating and the adhesion between the insulating coating and the electrical steel sheet although the insulating coating does not include a Cr compound. The expression "does not include a Cr compound" means that the Cr content in the dry coating is 0.1% by mass or less in terms of Cr in order to eliminate the impact of the Cr compound on corrosion resistance and the like and that the Cr content in the dry coating is 0.01% by mass or less in terms of Cr when consideration is given to the impact of the Cr compound on environment.

Impurities such as Hf, HfO₂, and TiO₂ may happen to be mixed in the insulating coating. The permissible total amount of the impurities included in the insulating coating is, for example, 5% by mass or less of the Zr content (in terms of the mass of ZrO₂). The amount of Zr included in the insulating coating is preferably set to 15% by mass or more and is further preferably set to 20% by mass of the total mass of the solid components in terms of the mass of ZrO₂.

A method for producing the electrical steel sheet provided with an insulating coating is described below.

The electrical steel sheet used for producing the electrical steel sheet provided with an insulating coating may be an electrical steel sheet produced by a common method or a commercially available electrical steel sheet.

In the present invention, a pretreatment for a material, that is, an electrical steel sheet, is not particularly specified. In other words, the electrical steel sheet is not necessarily subjected to a treatment. It is advantageous, though, to subject the electrical steel sheet to degreasing with an alkali or the like and pickling with hydrochloric acid, sulfuric acid, phosphoric acid, or the like.

A coating liquid used for forming an insulating coating is prepared. The coating liquid can be prepared, for example, by adding the following compounds and the like to deionized water.

The coating liquid contains a Zr compound in order to add Zr to the insulating coating. The coating liquid may contain at least one component selected from a Fe compound, a Si compound, a P compound, and an organic resin. Adding these components to the coating liquid enables an insulating coating including Fe, Si, P, and an organic resin to be formed. While it is necessary to add Fe to the insulating coating in the present invention, it is not necessary that the coating liquid contains a Fe compound as an essential component because Fe included in the electrical steel sheet may be introduced into the insulating coating instead.

The amounts of the above-described compounds and organic resin may be set appropriately depending on the desired contents of Zr and the like in the insulating coating. In other words, the molar ratio (Si/Zr), the molar ratio (P/Zr), and the solid content ratio of the organic resin can be controlled to be desired values in the step of preparing the coating liquid.

Examples of the Zr compound include zirconium acetate, zirconium propionate, zirconium oxychloride, zirconium nitrate, ammonium zirconium carbonate, potassium zirconium carbonate, zirconium hydroxychloride, zirconium sulfate, zirconium phosphate, sodium zirconium phosphate, potassium zirconium hexafluoride, zirconium tetra-N-propoxide, zirconium tetra-N-butoxide, zirconium tetraacetylacetonate, zirconium tributoxyacetylacetonate, and zirconium tributoxystearate. These Zr compounds may be used alone or in combination of two or more.

Examples of the Fe compound include iron acetate, iron citrate, and ammonium iron citrate. These Fe compounds may be used alone or in combination of two or more.

Examples of the Si compound include colloidal silica (particle diameter: 3 to 300 nm), fumed silica (specific surface area: 40 to 400 m²/g), alkoxysilanes, and siloxanes. These Si compounds may be used alone or in combination of two or more.

Examples of the P compound include phosphoric acids and phosphates. Examples of the phosphoric acids include orthophosphoric acid, anhydrous phosphoric acid, straight-chain polyphosphoric acid, and cyclic metaphosphoric acid. Examples of the phosphates include magnesium phosphate, aluminium phosphate, calcium phosphate, zinc phosphate, and ammonium phosphate. These P compounds may be used alone or in combination of two or more.

Conventionally used, publicly known organic resins can be suitably used as an organic resin. Examples thereof include aqueous resins (which form emulsions or dispersions or which are water-soluble), such as an acrylic resin, an alkyd resin, a polyolefin resin, a styrene resin, a vinyl acetate resin, an epoxy resin, a phenolic resin, a polyester resin, a urethane resin, and a melamine resin. An emulsion of an acrylic resin or ethylene-acrylic acid resin is particularly preferably used. These organic resins can be used alone or in combination of two or more. These organic resins may be used in the form of a copolymer.

Adding a surfactant, a rust-preventive agent, a lubricant, and the like to the coating liquid enables an insulating coating including these additives to be formed.

The pH of the coating liquid is preferably set, but not particularly limited, to 3 or more and 12 or less. The pH of the coating liquid is preferably set to 3 or more in order to limit an excessive increase in the Fe content in the coating. The pH of the coating liquid is preferably set to 12 or less in order to reduce the risk that the Fe content in the coating may become insufficient.

The above-described coating liquid is applied onto the surface of the electrical steel sheet, and the resulting electrical steel sheet is left standing for a certain period of time. While the electrical steel sheet is left standing for a certain period of time, elution of Fe included in the electrical steel sheet occurs and Fe migrates into the coating liquid. As a result, Fe can be added to the insulating coating. In order to add a specific amount of Fe to the insulating coating, the length of the standing time is preferably set to 3 to 220 seconds and is more preferably set to 10 to 100 seconds. It should be noted that the optimum standing time varies depending on the temperature of an atmosphere in which the electrical steel sheet is left standing (which is the room temperature, e.g., 10°C to 30°C), the pH of the coating liquid, and the composition of the electrical steel sheet. Accordingly, it is preferable to appropriately select the optimum standing time from 3 to 220 seconds or 10 to 100 seconds with consideration of the above-described factors.

A method for applying the above-described coating liquid onto the surface of the electrical steel sheet is not particularly specified, and may be any of the common industrial methods in which a roll coater, a flow coater, spraying, a knife coater, or the like is used.

The coating liquid deposited on the electrical steel sheet is baked to form an insulating coating. A baking method is not particularly specified, and common baking furnaces such as a hot-air heating furnace, an infrared heating furnace, and an induction heating furnace can be employed. The baking temperature is not particularly limited and may be set such that the temperature of the steel sheet reaches about 150°C to 350°C. The length of the baking time (i.e., time during which the steel sheet is placed in the furnace) is preferably set, but not particularly limited, to 1 to 600 seconds.

The electrical steel sheet provided with an insulating coating according to the present invention may be subjected to stress relief annealing in order to, for example, remove residual stress caused due to punching. Examples of a preferable atmosphere for stress relief annealing include a N₂ atmosphere and a DX gas atmosphere in which iron is not easily oxidized. It is possible to further enhance corrosion resistance by setting the dew point high, that is, for example, to Dp: about 5°C to 60°C, and by slightly oxidizing the surface and the cut end face. The stress relief annealing temperature is preferably set to 700°C to 900°C and is more preferably set to 700°C to 800°C. The holding time at the stress relief annealing temperature is preferably set long and is more preferably set to one hour or more.

The insulating coating is preferably disposed on both surfaces of the steel sheet, but may be disposed on only one surface of the steel sheet depending on the purpose. In another case, depending on the purpose, it is also possible to dispose the insulating coating according to the present invention on only one surface of the steel sheet and an insulating coating other than the insulating coating according to the present invention on the other surface.

### EXAMPLES

Coating liquids were each prepared by adding a specific one of the Zr compounds shown in Table 2, a specific one of the Si compounds shown in Table 3, a specific one of the P compounds shown in Table 4, and a specific one of the organic resin compounds shown in Table 5 to deionized water such that the resulting insulating had, after being dried, the molar ratio (Si/Zr), the molar ratio (P/Zr), and the solid content ratio (i.e., organic resin/Zr in the insulating coating) shown in Table 1 (hereinafter, Tables 1-1 and 1-2 are collectively referred to as "Table 1"). The concentration of the total solid content of the components relative to the amount of deionized water was set to 50 g/l. Table 1 summarizes the pH of each coating liquid. In Invention Example 12, iron acetate was added to the coating liquid such that the molar ratio (Fe/Zr) was 0.40 when elution of Fe included in the electrical steel sheet did not occur.

The coating liquids were each applied with a roll coater onto the surface of a specimen having a width of 150 mm and a length of 300 mm which was cut from an electrical steel sheet [A360 (JIS C 2552(2000)), W_{15/50}: 3.60 W/kg or less, B₅₀: 1.61 T or more] having a thickness of 0.35 mm.

The steel sheets on which the respective coating liquids were deposited were each left standing during the standing time shown in Table 1. The amount of each coating liquid deposited was controlled such that the resulting coating had the Zr content shown in Table 1.

The temperature of an atmosphere in which the steel sheets were left standing was 25°C. After being left standing in the above-described manner, the resulting coatings had the molar ratios (Fe/Zr) shown in Table 1. A method for determining the molar ratios (Fe/Zr) will be described later.

The steel sheets that had been left standing in the above-described manner were each baked in a hot-air baking furnace at the baking temperature (i.e., temperature to which the steel sheet was heated) during the baking time (i.e., time during which the steel sheet was placed in the furnace) shown in Table 1. The baked steel sheets were left standing to cool to the normal temperature. Thus, insulating coatings were formed.

Table 1 summarizes the results of determining the coating characteristics of each electrical steel sheet provided with an insulating coating (i.e., product sheets). Coating characteristics were evaluated in the following manner. In addition, the coating characteristics of stress-relief-annealed electrical steel sheets provided with an insulating coating (i.e., annealed sheets), which were prepared by subjecting each electrical steel sheet provided with an insulating coating to stress relief annealing in a nitrogen atmosphere at 750°C for 2 hours, were also determined in the same manner as for the product sheets. Table 1 summarizes the results.

### <Molar Ratio (Fe/Zr)>

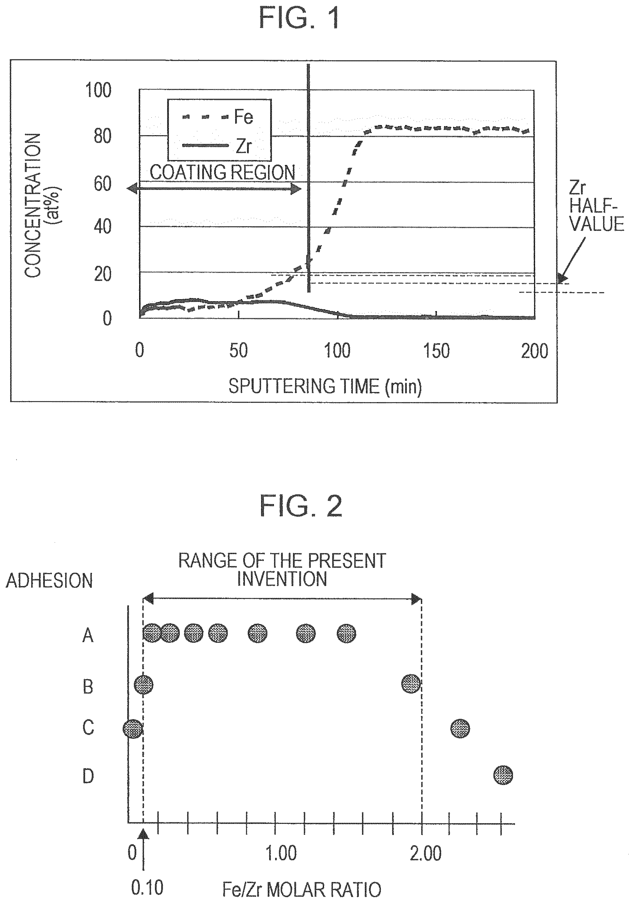

An analysis was conducted using an Auger electron spectrometer (produced by Physical Electronics, Inc.) at an acceleration voltage of 10 keV and a specimen current of 0.2 µA. Depth profiling was conducted at a sputter rate of 3 nm/min (in terms of SiO₂) with 2-min pitches until the count of Zr was reduced to a noise level. The average of values measured at points above the position at which the Zr count was reduced to half the initial value was calculated. Fig. 1 illustrates an example of the depth profiling. The molar ratio (Fe/Zr) was determined on the basis of the results of the above-described analysis.

### <Corrosion Resistance>

The electrical steel sheets provided with an insulating coating and the stress-relief-annealed electrical steel sheets provided with an insulating coating were each subjected to a humidity cabinet test (50°C, relative humidity ≥ 98%), and the red rust area ratio (i.e., ratio of the area in which red rust was present) after 48 hours was visually inspected. Corrosion resistance was evaluated on the basis of the red rust area ratio in accordance with the following criteria.

### (Evaluation Criteria)

A: Red rust area ratio Less than 20%
B: Red rust area ratio 20% or more and less than 40%
C: Red rust area ratio 40% or more and less than 60%
D: Red rust area ratio 60% or more

### <Adhesion>

A cellophane adhesive tape was stuck on the surface of each electrical steel sheet provided with an insulating coating and the surface of each stress-relief-annealed electrical steel sheet provided with an insulating coating. After the electrical steel sheet was bent inward at φ10 mm, the cellophane tape was removed from the electrical steel sheet. Evaluation was made by visually inspecting the condition of the insulating coating remaining on the electrical steel sheet in accordance with the following criteria.

### (Evaluation Criteria)

A: Residual ratio 90% or more
B: Residual ratio 60% or more and less than 90%
C: Residual ratio 30% or more and less than 60%
D: Residual ratio Less than 30%
[Table 1-1]

**Table 1**

| No. | pH of coating liquid | Components of insulating coating | | | | | | | | | Production conditions | | | Coating characteristics | | | |
|---|---|---|---|---|---|---|---|---|---|---|---|---|---|---|---|---|---|
| | | Inorganic components | | | | | | | Organic resin | | Standing time (sec) | Baking temperature (°C) | Baking time (sec) | Corrosion rsistance | | Adhesion | |
| | | Zr compound | | Fe/Zr | Si compound | | P compound | | Type | Solid content (organic resin/Zr) | | | | Product sheet | Annealed sheet | Product sheet | Annealed sheet |
| | | Type | Zr content in terms of ZrO₂ (g/m²) | Molar ratio (Fe/Zr) | Type | Molar ratio (Si/Zr) | Type | Molar ratio (P/Zr) | | | | | | | | | |
| Comparative example 1 | 9.1 | Z1 | 0.50 | 0.06 | - | - | - | - | - | - | 5 | 250 | 30 | C | C | C | C |
| Invention example 1 | 9.2 | Z1 | 0.50 | 0.14 | - | - | - | - | - | - | 10 | 250 | 30 | B | B | B | B |
| Invention example 2 | 9.2 | Z1 | 0.50 | 0.22 | - | - | - | - | - | - | 15 | 250 | 30 | B | B | A | B |
| Invention example 3 | 9.1 | Z1 | 0.50 | 0.31 | - | - | - | - | - | - | 15 | 250 | 30 | B | B | A | B |
| Invention example 4 | 9.2 | Z1 | 0.50 | 0.48 | - | - | - | - | - | - | 30 | 250 | 30 | B | B | A | B |
| Invention example 5 | 9.3 | Z1 | 0.50 | 0.62 | - | - | - | - | - | - | 40 | 250 | 30 | B | B | A | B |
| Invention example 6 | 9.2 | Z1 | 0.50 | 0.89 | - | - | - | - | - | - | 50 | 250 | 30 | B | B | A | B |
| Invention example 7 | 9.1 | Z1 | 0.50 | 1.22 | - | - | - | - | - | - | 60 | 250 | 30 | B | B | A | B |
| Invention example 8 | 9.2 | Z1 | 0.50 | 1.54 | - | - | - | - | - | - | 100 | 250 | 30 | B | B | A | B |
| Invention example 9 | 9.3 | Z1 | 0.50 | 1.95 | - | - | - | - | - | - | 200 | 250 | 30 | B | B | B | B |
| Comparative example 2 | 9.2 | Z1 | 0.50 | 2.31 | - | - | - | - | - | - | 300 | 250 | 30 | C | C | C | C |
| Comparative example 3 | 9.1 | Z1 | 0.50 | 2.63 | - | - | - | - | - | - | 400 | 250 | 30 | D | D | D | D |
| Invention example 10 | 9.2 | Z2 | 0.50 | 0.43 | - | - | - | - | - | - | 30 | 250 | 30 | B | B | A | B |
| Invention example 11 | 4.7 | Z3 | 0.50 | 0.40 | - | - | - | - | - | - | 10 | 250 | 30 | B | B | A | B |
| Invention example 12 | 4.7 | Z3 | 0.50 | 1.02* | - | - | - | - | - | - | 10 | 250 | 30 | B | B | A | B |
| Comparative example 4 | 9.2 | Z1 | 0.01 | 0.43 | - | - | - | - | - | - | 30 | 250 | 30 | D | D | B | B |
| Comparative example 5 | 9.1 | Z1 | 0.02 | 0.43 | - | - | - | - | - | - | 30 | 250 | 30 | C | C | B | B |
| Invention example 13 | 9.3 | Z1 | 0.05 | 0.45 | - | - | - | - | - | - | 30 | 250 | 30 | B | B | B | B |
| Invention example 14 | 9.2 | Z1 | 0.20 | 0.51 | - | - | - | - | - | - | 30 | 250 | 30 | B | B | A | B |

| | | | | | | | | | | | | | | | | | |
|---|---|---|---|---|---|---|---|---|---|---|---|---|---|---|---|---|---|
| * Iron acetate was added | | | | | | | | | | | | | | | | | |

[Table 1-2]

**Table 1**

| No. | pH of coating liquid | Components of insulating coating | | | | | | | | | Production conditions | | | Coating characteristics | | | |
|---|---|---|---|---|---|---|---|---|---|---|---|---|---|---|---|---|---|
| | | Inorganic components | | | | | | | Organic resin | | Standing time (sec) | Baking temperature (°C) | Baking time (sec) | Corrosion rsistance | | Adhesion | |
| | | Zr compound | | Fe/Zr | Si compound | | P compound | | Type | Solid content (organic resin/Zr) | | | | Product sheet | Annealed sheet | Product sheet | Annealed sheet |
| | | Type | Zr content in terms of ZrO₂ (g/m²) | Molar ratio (Fe/Zr) | Type | Molar ratio (Si/Zr) | Type | Molar ratio (P/Zr) | | | | | | | | | |
| Invention example 15 | 9.4 | Z1 1 | 1.00 | 0.46 | - | - | - | - | - | - | 30 | 250 | 30 | B | B | A | B |
| Invention example 16 | 9.3 | Z1 | 1.50 | 0.52 | - | - | - | - | - | - | 30 | 250 | 30 | B | B | B | B |
| Comparative example 6 | 9.2 | Z1 | 1.70 | 0.43 | - | - | - | - | - | - | 30 | 250 | 30 | C | C | C | C |
| Comparative example 7 | 9.1 | Z1 | 2.00 | 0.43 | - | - | - | - | - | - | 30 | 250 | 30 | D | D | D | D |
| Comparative example 8 | 9.2 | Z1 | 0.50 | 0.05 | S1 | 1.00 | - | - | - | - | 5 | 250 | 30 | C | C | B | B |
| Invention example 17 | 9.0 | Z1 | 0.50 | 0.55 | S1 | 0.30 | - | - | - | - | 30 | 250 | 30 | B | B | A | A |
| Invention example 18 | 9.0 | Z1 | 0.50 | 0.52 | S1 | 1.00 | - | - | - | - | 30 | 250 | 30 | B | B | A | A |
| Invention example 19 | 9.1 | Z1 | 0.50 | 0.49 | S2 | 1.50 | - | - | - | - | 30 | 250 | 30 | B | B | A | A |
| Invention example 20 | 9.2 | Z1 | 0.50 | 0.61 | S3 | 2.00 | - | - | - | - | 30 | 250 | 30 | B | B | A | A |
| Invention example 21 | 9.2 | Z1 | 0.50 | 0.67 | S3 | 2.50 | - | - | - | - | 30 | 250 | 30 | B | B | B | A |
| Comparative example 9 | 9.1 | Z1 | 0.50 | 0.06 | - | - | P2 | 1.00 | - | - | 5 | 250 | 30 | B | B | B | C |
| Invention example 22 | 9.3 | Z1 | 0.50 | 0.66 | - | - | P1 | 0.20 | - | - | 30 | 250 | 30 | A | B | A | B |
| Invention example 23 | 9.3 | Z1 | 0.50 | 0.74 | - | - | P1 | 0.50 | - | - | 30 | 250 | 30 | A | A | A | B |
| Invention example 24 | 9.2 | Z1 | 0.50 | 0.62 | - | - | P2 | 1.00 | - | - | 30 | 250 | 30 | A | A | A | B |
| Invention example 25 | 9.1 | Z1 | 0.50 | 0.53 | - | - | P2 | 1.50 | - | - | 30 | 250 | 30 | A | A | A | B |
| Invention example 26 | 9.3 | Z1 | 0.50 | 0.49 | - | - | P2 | 2.00 | - | - | 30 | 250 | 30 | B | B | A | B |
| Comparative example 10 | 9.2 | Z1 | 0.50 | 0.04 | - | - | - | - | R1 | 0.50 | 5 | 250 | 30 | B | C | B | C |
| Invention example 27 | 9.1 | Z1 | 0.50 | 0.49 | - | - | - | - | R1 | 0.50 | 30 | 250 | 30 | A | B | A | B |
| Invention example 28 | 9.0 | Z1 | 0.50 | 0.53 | - | - | - | - | R1 | 1.00 | 30 | 250 | 30 | B | B | B | B |
| Invention example 29 | 9.1 | Z1 | 0.50 | 0.51 | S2 | 1.00 | - | - | R2 | 0.50 | 30 | 250 | 30 | A | B | A | A |
| Invention example 30 | 9.2 | Z1 | 0.50 | 0.48 | - | - | P2 | 1.00 | R3 | 0.50 | 30 | 250 | 30 | A | A | A | B |
| Invention example 31 | 9.1 | Z1 | 0.50 | 0.57 | S2 | 1.00 | P2 | 1.00 | R4 | 0.50 | 30 | 250 | 30 | A | A | A | A |

| | | | | | | | | | | | | | | | | | |
|---|---|---|---|---|---|---|---|---|---|---|---|---|---|---|---|---|---|
| * Iron acetate was added | | | | | | | | | | | | | | | | | |

[Table 2]

**Table 2**

| Symbol | Name | Chemical formula | Maker | Trade name |
|---|---|---|---|---|
| Z1 | Ammonium zirconium carbonate | (NH₄)₂{Zr(CO₃)₂(OH)₂)} | Daiichi Kigenso Kagagu | Zircosol (Registered Trademark) AC-20 |
| Z2 | Potassium zirconium carbonate | K₂{Zr(CO₃)₂(OH)₂)} | Nippon Light Metal | Zirmel 1000 |
| Z3 | Zirconium acetate | (CH₃CO₂)ₙZr | Daiichi Kigenso Kagagu | Zircosol (Registered Trademark) ZA-20 |

[Table 3]

**Table 3**

| Symbol | Maker | Classification | Trade name | Particle diameter/specific surface area |
|---|---|---|---|---|
| S1 | Nissan Chemical Industries | Colloidal silica | SNOWTEX (Registered Trademark) O | 10 to 20 nm |
| S2 | Nissan Chemical Industries | Colloidal silica | SNOWTEX (Registered Trademark) N | 10 to 20 nm |
| S3 | Evonik Degussa Japan | Fumed silica | AEROSIL (Registered Trademark) 200 | 200 m²/g |

[Table 4]

**Table 4**

| Symbol | Name | Chemical formula |
|---|---|---|
| P1 | Phosphoric acid | H₃PO₄ |
| P2 | Ammonium phosphate | (NH₄)₃PO₄ |

[Table 5]

**Table 5**

| Symbol | Name | Maker | Trade name |
|---|---|---|---|
| R1 | Epoxy resin | DIC | - |
| R2 | Polyester resin | Toyobo | Vylonal (Registered Trademark) MD1200 |
| R3 | Acrylic resin | DIC | VONCOAT (Registered Trademark) CP6140 |
| R4 | Urethane resin | ADEKA | ADEKA BONTIGHTER (Registered Trademark) HUX |

As shown in Table 1, all the electrical steel sheets provided with an insulating coating prepared in accordance with the present invention had high corrosion resistance and high adhesion.

In contrast, the comparative examples, in which the Zr compound was outside the appropriate range, had low corrosion resistance and low adhesion.

Fig. 2 illustrates the relationship between the adhesion between the insulating coating and the electrical steel sheet and the molar ratio (Fe/Zr) which was determined using the electrical steel sheets provided with an insulating coating that had not yet been subjected to stress relief annealing. It can be confirmed from Fig. 2 that adding a certain amount of Fe to a Zr-containing insulating coating markedly enhanced the coating characteristics.

## Claims

1. An electrical steel sheet provided with an insulating coating, the electrical steel sheet provided with an insulating coating comprising:
an electrical steel sheet; and
an insulating coating disposed on the electrical steel sheet,
wherein the insulating coating includes Zr and Fe,
wherein the content of Zr in the insulating coating is 0.05 to 1.50 g/m² in terms of ZrO₂, and
wherein the compositional ratio between Zr and Fe is such that the molar ratio of Fe to Zr, that is, the ratio of the amount (moles) of Fe included in the insulating coating to the amount (moles) of Zr included in the insulating coating, is 0.10 to 2.00.

2. The electrical steel sheet provided with an insulating coating according to Claim 1,
wherein the insulating coating further includes Si, and
wherein the compositional ratio between Zr and Si is such that the molar ratio of Si to Zr, that is, the ratio of the amount (moles) of Si included in the insulating coating to the amount (moles) of Zr included in the insulating coating, is 2.00 or less.

3. The electrical steel sheet provided with an insulating coating according to Claim 1 or 2,
wherein the insulating coating further includes P, and
wherein the compositional ratio between Zr and P is such that the molar ratio of P to Zr, that is, the ratio of the amount (moles) of P included in the insulating coating to the amount (moles) of Zr included in the insulating coating, is 1.50 or less.

4. The electrical steel sheet provided with an insulating coating according to any one of Claims 1 to 3,
wherein the insulating coating further includes an organic resin, and
wherein the compositional ratio between Zr and the organic resin is such that the solid content ratio of the organic resin to Zr, that is, the ratio of the solid content (g) of the organic resin included in the insulating coating to the amount (g) of Zr included in the insulating coating in terms of the mass of ZrO₂, is 0.50 or less.

## Patentansprüche

1. Elektrisches Stahlblech, das mit einer isolierenden Beschichtung versehen ist, wobei die elektrische Stahlschicht, die mit einer isolierenden Beschichtung versehen ist, aufweist:
eine elektrische Stahlschicht; und
eine isolierende Beschichtung, die auf der elektrischen Stahlschicht angeordnet ist,
wobei die isolierende Beschichtung Zr und Fe enthält,
wobei der Anteil an Zr in der isolierenden Beschichtung 0,05 bis 1,50 g/m² in Bezug auf ZrO₂ beträgt, und
wobei das Zusammensetzungsverhältnis zwischen Zr und Fe so ist, dass das Molverhältnis von Fe zu Zr, d. h., das Verhältnis des Anteils (Mol) an Fe, der in der isolierenden Beschichtung enthalten ist, zu dem Anteil (Mol) von Zr, der in der isolierenden Beschichtung enthalten ist, 0,10 bis 2,00 beträgt.

2. Elektrisches Stahlblech, das mit einer isolierenden Beschichtung versehen ist, nach Anspruch 1,
wobei die isolierende Beschichtung ferner Si enthält, und
wobei das Zusammensetzungsverhältnis zwischen Zr und Si derart ist, dass das Molverhältnis von Si zu Zr, d. h., das Verhältnis des Anteils (Mol) von Si, der in der isolierenden Beschichtung enthalten ist, zu dem Anteil (Mol) von Zr, der in der isolierenden Beschichtung enthalten ist, 2,00 oder weniger beträgt.

3. Elektrisches Stahlblech, das mit einer isolierenden Beschichtung versehen ist, nach Anspruch 1 oder 2,
wobei die isolierende Beschichtung ferner P enthält, und
wobei das Zusammensetzungsverhältnis zwischen Zr und P derart ist, dass das Molverhältnis von P zu Zr, d. h., das Verhältnis des Anteils (Mol) von P, der in der isolierenden Beschichtung enthalten ist, zu dem Anteil (Mol) an Zr der in der isolierenden Beschichtung enthalten ist, 1,50 oder weniger beträgt.

4. Elektrisches Stahlblech, das mit einer isolierenden Beschichtung versehen ist, nach einem der Ansprüche 1 bis 3,
wobei die isolierende Beschichtung ferner ein organisches Harz enthält, und
wobei das Zusammensetzungsverhältnis zwischen Zr und dem organischen Harz derart ist, dass das Feststoffanteilverhältnis des organischen Harzes zu Zr, d. h. das Verhältnis des in der isolierenden Beschichtung enthaltenen Feststoffanteils (g) des organischen Harzes zu dem Anteil (g) an Zr, der in der isolierenden Beschichtung in Bezug auf die Masse von ZrO₂ enthalten ist, 0,50 oder weniger beträgt.

## Revendications

1. Tôle d'acier électrique pourvue d'un revêtement isolant, la tôle d'acier électrique pourvue d'un revêtement isolant comprenant :
une tôle d'acier électrique ; et
un revêtement isolant disposé sur la tôle d'acier électrique,
où le revêtement isolant comprend Zr et Fe,
où la teneur en Zr dans le revêtement isolant va de 0,05 à 1,50 g/m² en termes de ZrO₂, et
où le rapport compositionnel entre Zr et Fe est tel que le rapport molaire de Fe à Zr, c'est-à-dire le rapport de la quantité (en moles) de Fe comprise dans le revêtement isolant à la quantité (en moles) de Zr comprise dans le revêtement isolant, va de 0,10 à 2,00.

2. Tôle d'acier électrique pourvue d'un revêtement isolant selon la revendication 1,
où le revêtement isolant comprend en outre Si, et
où le rapport compositionnel entre Zr et Si est tel que le rapport molaire de Si à Zr, c'est-à-dire le rapport de la quantité (en moles) de Si comprise dans le revêtement isolant à la quantité (en moles) de Zr comprise dans le revêtement isolant, est inférieur ou égal à 2,00.

3. Tôle d'acier électrique pourvue d'un revêtement isolant selon la revendication 1 ou 2,
où le revêtement isolant comprend en outre P, et
où le rapport compositionnel entre Zr et P est tel que le rapport molaire de P à Zr, c'est-à-dire le rapport de la quantité (en moles) de P comprise dans le revêtement isolant à la quantité (en moles) de Zr comprise dans le revêtement isolant, est inférieur ou égal à 1,50.

4. Tôle d'acier électrique pourvue d'un revêtement isolant selon l'une quelconque des revendications 1 à 3,
où le revêtement isolant comprend en outre une résine organique, et
où le rapport compositionnel entre Zr et la résine organique est tel que le rapport de teneur solide de la résine organique à Zr, c'est-à-dire le rapport de la teneur solide (en grammes) de la résine organique comprise dans le revêtement isolant à la quantité (en grammes) de Zr comprise dans le revêtement isolant en termes de masse de ZrO₂, est inférieur ou égal à 0,50.
